# EUROPEAN PATENT APPLICATION

(11) **EP 4 583 644 A1**
(43) Date of publication of application: **09.07.2025**
(21) Application number: 22957331.6
(22) Date of filing: 30.08.2022
(51) Int. Cl.: H05K 3/12

(54) **PATTERN FORMING METHOD AND BAKING DEVICE**

(71) Applicant: Komori Corporation, Tokyo 130-8666 (JP)
(72) Inventor: OSHIMA, Shingo, Tsukuba-shi, Ibaraki 300-1268 (JP); IKEDA, Hideki, Tsukuba-shi, Ibaraki 300-1268 (JP)
(74) Representative: Samson & Partner Patentanwälte mbB
(86) International application number: PCT/JP2022/032513
(87) International publication number: WO 2024/047728

(57) **Abstract**

A resin substrate (111), on which a paste pattern (112) of a metal paste is formed, is fixed on a fixing plate (101) made of a metal having a thermal capacity per unit volume of 3,000 [kJ/m³·K] or more and a thermal conductivity of 45 [W/m·K] or more, and the paste pattern (112) is baked by irradiating the paste pattern (112) formed on the resin substrate (111) fixed to the fixing plate (101) with near infrared rays emitted from a light source (102), thereby forming a conductive pattern on the resin substrate (111). A peak wavelength range of the irradiated near infrared rays is 0.8 to 1.7 µm.

## Description

### Technical Field

The present invention relates to a pattern forming method and a baking apparatus.

### Background Art

In the field of printed electronics such as a printed wiring board, formation of wiring for a resin substrate has been studied extensively. For example, there has been developed a technique of forming a wiring pattern by screen printing or the like. When manufacturing a wiring board of this type, steps such as pattern formation and heating (baking) are performed. Heating of this type is generally mainly performed by lamp annealing using infrared rays (see patent literature 1).

### Related Art Literature

### Patent Literature

Patent Literature 1: Japanese Patent No. 4956696

### Disclosure of Invention

### Problem to be Solved by the Invention

Many printed wiring boards using flexible substrates have been used at present. As the material of a flexible substrate of this type, a resin such as polyethylene terephthalate (PET) or polyethylene naphthalate (PEN) is used. Since the material of this type has low heat resistance, the irradiation intensity cannot be made high in conventional heating using infrared irradiation. If baking is executed using a high irradiation intensity, the resin substrate is deformed, and a formed pattern peels off. For this reason, in the conventional technique, since processing is performed using a low irradiation intensity, the step of baking takes long time.

The present invention has been made to solve the above-described problem, and has as its object to execute baking of a conductive paste in a shorter time even if a substrate of a resin having a low heat resistance is used.

### Means of Solution to the Problem

According to the present invention, there is provided a pattern forming method comprising fixing a resin substrate, on which a paste pattern of a conductive paste is formed, on a fixing plate made of a metal having a thermal capacity per unit volume of 3,000 [kJ/m³·K] or more and a thermal conductivity of 45 [W/m·K] or more, and baking the paste pattern by irradiating the paste pattern formed on the resin substrate fixed to the fixing plate with near infrared rays, thereby forming a conductive pattern on the resin substrate.

In a configuration example of the pattern forming method, a peak wavelength range of the near infrared rays is 0.8 to 1.7 µm.

In a configuration example of the pattern forming method, the resin substrate is fixed to the fixing plate by a fixing mechanism.

In a configuration example of the pattern forming method, the fixing mechanism is an adhesive layer that fixes the resin substrate to the fixing plate.

According to the present invention, there is provided a baking apparatus comprising a fixing plate made of a metal having a thermal capacity per unit volume of 3,000 [kJ/m³·K] or more and a thermal conductivity of 45 [W/m·K] or more, and a light source configured to irradiate, with near infrared rays, a paste pattern on a resin substrate which is fixed on the fixing plate and on which the paste pattern of a conductive paste is formed.

In a configuration example of the baking apparatus, a peak wavelength range of the near infrared rays is 0.8 to 1.7 µm.

In a configuration example of the baking apparatus, the apparatus further comprises a fixing mechanism configured to fix the resin substrate to the fixing plate.

In a configuration example of the baking apparatus, the fixing mechanism is formed by an adhesive layer.

### Effect of the Invention

As described above, according to the present invention, since baking is executed by irradiation of near infrared rays on a fixing plate made of a metal which has a thermal capacity per unit volume of 3,000 [kJ/m³·K] or more and a thermal conductivity of 45 [W/m·K] or more, baking of a conductive paste can be executed in a shorter time even if a substrate of a rein having a low heat resistance is used.

### Brief Description of Drawings

Fig. 1 is a view showing the configuration of a baking apparatus according to the embodiment of the present invention; and
Fig. 2 is a flowchart for explaining a pattern forming method according to the embodiment of the present invention.

### Best Mode for Carrying Out the Invention

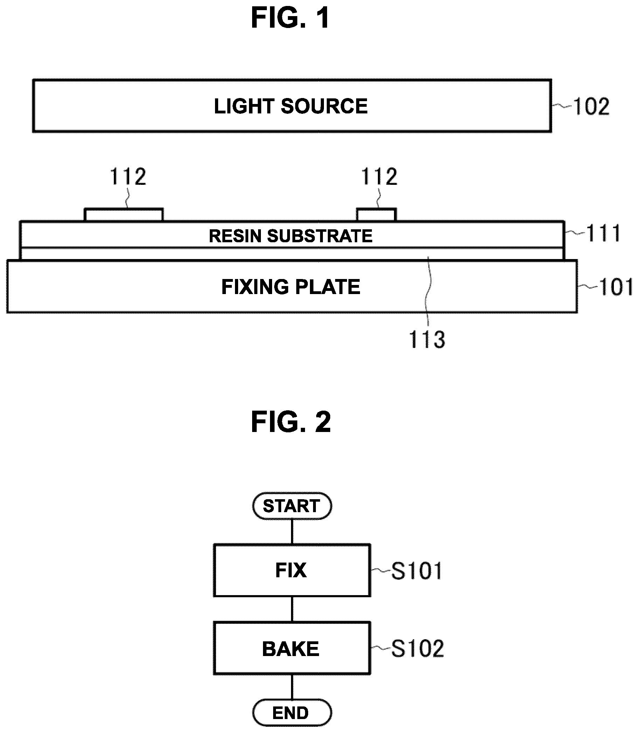

A baking apparatus according to the embodiment of the present invention will now be described with reference to Fig. 1. The baking apparatus includes a fixing plate 101 and a light source 102.

The fixing plate 101 is made of a metal having a thermal capacity per unit volume of 3,000 [kJ/m³·K] or more and a thermal conductivity of 45 [W/m·K] or more. The thermal capacity per unit volume [kJ/m³·K] can be obtained by specific heat [kJ/kg·K] × density [kg/m³], which are unique physical property values of an object. The fixing plate 101 can have a plate thickness of, for example, 0.3 mm or more. The fixing plate 101 can be made of, for example, copper. The fixing plate 101 can also be made of red brass whose copper composition is 84% to 96%. The fixing plate 101 can also be made of brass whose copper composition is 59 to 71.5%. The fixing plate 101 can also be made of aluminum bronze. The fixing plate 101 can also be made of tungsten steel. The fixing plate 101 can also be made of a rolled steel plate.

The light source 102 irradiates, with near infrared rays, a paste pattern 112 on a resin substrate 111 which is fixed on the fixing plate 101 and on which the paste pattern 112 of a conductive paste is formed. The peak wavelength range of the near infrared rays is 0.8 to 1.7 µm. The light source 102 is instructed on the fixing plate 101 by a support portion (not shown). The light source 102 can be arranged at a point apart by about 100 mm from the surface of the resin substrate 111. The light source 102 can be formed by, for example, a plurality of near infrared lamps. The light source 102 can use, for example, NIR series available from Adphos.

The baking apparatus can also include a fixing mechanism 113 that fixes the resin substrate 111 to the fixing plate 101. The fixing mechanism 113 can be formed by, for example, an adhesive layer made of a substance having adhesive properties. The fixing mechanism 113 may be formed by, for example, an adhesive layer formed by applying a gelatinous adhesive substance or a sheet of elastomer having adhesive properties.

A pattern forming method according to the embodiment of the present invention will be described next with reference to Fig. 2. A pattern forming method using the above-described baking apparatus will be described below.

First, in first step S101, the resin substrate 111 on which the paste pattern 112 of a conductive paste is formed is fixed on the fixing plate 101 made of a metal having a thermal capacity per unit volume of 3,000 [kJ/m³·K] or more and a thermal conductivity of 45 [W/m·K] or more. The resin substrate 111 can be fixed to the fixing plate 101 by the fixing mechanism 113. The fixing mechanism 113 can be an adhesive layer that fixes the resin substrate 111 to the fixing plate 101.

The resin substrate 111 is made of, for example, a resin such as polyethylene terephthalate, polycarbonate, polypropylene, polyethylene naphthalate, or polyimide (PI). The resin substrate 111 has a sheet shape having a thickness of, for example, 30 µm to 10 mm.

The conductive paste can be formed by, for example, dispersing fine metal particles of gold, silver, copper, aluminum, nickel, zinc, or tin or conductive fine carbon particles in a resin binder. The conductive paste is, for example, a nano silver paste available from Fujikura Kasei. The paste pattern 112 can be formed by, for example, a well-known screen printing method. The paste pattern 112 can also be formed by an inkjet method. The paste pattern 112 can have a thickness of, for example, 2 to 10 µm. Depending on the resin binder to be used, the thickness of the paste pattern 112 can be 25 µm.

Next, in second step S102, the paste pattern 112 formed on the resin substrate 111 fixed to the fixing plate 101 is irradiated with near infrared rays emitted from the light source 102, thereby baking the paste pattern 112 and thus forming a conductive pattern on the resin substrate 111. The conductive pattern is, for example, a metal pattern. The peak wavelength range of the irradiated near infrared rays is 0.8 to 1.7 µm.

In the paste pattern 112 irradiated with the near infrared rays (peak wavelength range: 0.8 to 1.7 µm), the contained fine metal particles absorb the irradiated near infrared rays and generate heat. On the other hand, the resin substrate 111 does not absorb the irradiated near infrared rays very well, so it does not generate much heat. For this reason, the paste pattern 112 is selectively heated by irradiation of the near infrared rays. It is therefore possible to, in a state in which a rise of the temperature of the resin substrate 111 is suppressed, make the irradiation intensity of near infrared rays high and selectively heat the paste pattern 112 to a high temperature.

On the other hand, since the paste pattern 112 is heated, the resin substrate 111 at the point where the paste pattern 112 is formed is heated. The heat of the resin substrate 111 is conducted to the fixing plate 101 and diffused. As a result, the rise of heat is suppressed even in the resin substrate 111 at the point where the paste pattern 112 is formed.

As a result, according to the embodiment, baking of the paste pattern 112 can more quickly be executed in a short time in a state in which an occurrence of damages to the resin substrate 111 is prevented. For example, baking of the paste pattern 112 can be executed with a processing time of 30 sec to 1 min.

Table 1 shows the result of an experiment. In the experiment, a predetermined pattern of a conductive paste (nano silver paste available from Fujikura Kasei) was formed on each of resin substrates (sheets) made of materials shown in Table 1, and heating (lamp annealing) was executed for 1 min using each lamp.

As for a light source "near infrared rays", three near infrared lamps with a peak wavelength of 0.8 to 1.7 µm were used, and conditions of a total output of 13 kw and an energy density of 380 kw/m² were set. As for a light source "Xe lamp", an Xe lamp with a peak wavelength of 0.4 to 0.6 µm was used. As for a light source "far infrared rays", one far infrared lamp with a peak wavelength of 3 to 4 µm was used, the total output was set to 1.25 kw, and the energy density was set to 40 kw/m².

Also, a wiring pattern having a pattern size of "30 µm or less" and a line width of 30 µm or less was formed, a wiring pattern having a pattern size of "1,000 µm" and a line width of 1,000 µm or less was formed, and a square pattern having a pattern size of "10 mm" and a one-side length of 10 mm was formed. The thicknesses of the patterns were 2 to 10 µm.

Under the above-described conditions, conduction of each pattern was confirmed in a processing time of 1 min or less, and if deformation of the resin substrate (sheet) was not observed, the determination result of the sample was "○". If the above-described conditions were not satisfied, the determination was result was "×". The conduction was determined based on a resistance value for 90% or more of baking using a hot air drying furnace.

**[Table 1]**

| Light source | Substrate condition | | | | PET | | | PEN | | | PI | | |
|---|---|---|---|---|---|---|---|---|---|---|---|---|---|
| | materials | plate thickness [mm] | thermal capacity [kJ /m³·K] | thermal conductivity [W/m·K] | pattern size | | | pattern size | | | pattern size | | |
| | | | | | 30 µm or less | 1,000 µm | 10 mm | 30 µm or less | 1,000 µm | 10 mm | 30 µm or less | 1,000 µm | 10 mm |
| Near infrared rays | sheet glass | 3 | 2092.5 | 1 | × | × | × | × | × | × | ○ | ○ | ○ |
| | touch pitch copper | 1,3,5,10 | 3422.65 | 391 | ○ | ○ | ○ | ○ | ○ | ○ | ○ | ○ | ○ |
| | red brass (Cu94-96) | 1,3,5 | 3340.22 | 234 | ○ | ○ | ○ | ○ | ○ | ○ | ○ | ○ | ○ |
| | red brass (Cu89-91) | 1,3,5 | 3317.6 | 188 | ○ | ○ | ○ | ○ | ○ | ○ | ○ | ○ | ○ |
| | red brass (Cu84-86) | 1,3,5 | 3298.75 | 159 | ○ | ○ | ○ | ○ | ○ | ○ | ○ | ○ | ○ |
| | red brass (Cu78.5-81.5) | 1,3,5 | 3268.59 | 138 | ○ | ○ | ○ | ○ | ○ | ○ | ○ | ○ | ○ |
| | 7-3 brass (Cu68.5-71.5) | 1,3,5 | 3215.81 | 121 | ○ | ○ | ○ | ○ | ○ | ○ | ○ | ○ | ○ |
| | 6-4 brass (Cu59-62) | 1,3,5 | 3163.03 | 121 | ○ | ○ | ○ | ○ | ○ | ○ | ○ | ○ | ○ |
| | aluminum bronze (Cu-Al-Zn) | 1,3,5 | 3135 | 80 | ○ | ○ | ○ | ○ | ○ | ○ | ○ | ○ | ○ |
| | gunmetal (Cu-Sn-Pb-Zn) | 1,3,5 | 3344 | 159 | ○ | ○ | ○ | ○ | ○ | ○ | ○ | ○ | ○ |
| | tungsten steel | 1,3,5 | 3530.24 | 66 | ○ | ○ | ○ | ○ | ○ | ○ | ○ | ○ | ○ |
| | rolled steel for general structure | 1,3,5 | 3713.05 | 51.6 | ○ | ○ | ○ | ○ | ○ | ○ | ○ | ○ | ○ |
| | carbon steel | 1,3,5 | 3841.6 | 45 | ○ | ○ | ○ | ○ | ○ | ○ | ○ | ○ | ○ |
| | pure aluminum | 1,3,5 | 2439 | 222 | × | × | × | × | × | × | ○ | ○ | ○ |
| | aluminum alloy (Mg) | 1,3,5 | 2412 | 137 | × | × | × | × | × | × | ○ | ○ | ○ |
| | stainless steel | 1,3,5 | 3965 | 16 | × | × | × | × | × | × | ○ | ○ | ○ |
| | nickel silver (Cu-Ni-Zn) | 1,3,5 | 3439.62 | 33 | × | × | × | × | × | × | ○ | ○ | ○ |
| Xe lamp | all materials | | | | × | × | × | × | × | × | × | × | × |
| Far infrared rays | all materials | | | | × | × | × | × | × | × | × | × | × |

As shown in Table 1, in the substrate made of a metal which has a thermal capacity per unit volume of 3,000 [kJ/m³·K] or more and a thermal conductivity of 45 [W/m·K] or more, the determination result is "○".

As described above, according to the present invention, since baking is executed by irradiation of near infrared rays on the fixing plate made of a metal having a thermal capacity per unit volume of 3,000 [kJ/m³·K] or more and a thermal conductivity of 45 [W/m·K] or more, it is possible to execute baking of a conductive paste in a shorter time even if a substrate of a resin having a low heat resistance is used.

For example, formation of a wiring pattern (conductive pattern) on a printed board or the like is executed by screen printing, and the time needed to form a wiring pattern of one layer is about 1 min. To the contrary, a baking/drying step that is generally performed at present to bake a wiring pattern to form wires takes a time of several ten min to 1 hr or more, and the challenge is how to shorten the time required for the baking/drying step.

In addition, as a new material of a flexible substrate, a synthetic resin such as PET, PEN, or PI is used. The synthetic resins other than PI have a low heat resistance, and manufacturing defects (cracks in a printed portion, peeling, holes in a substrate, deformation, and the like) may occur due to the high temperature in baking or drying. However, according to the present invention, it is possible to suppress thermal deformation in resin substrate manufacturing and efficiently manufacture substrates in a short time.

Note that the present invention is not limited the above-described embodiments, and it is obvious that many modifications and combinations can be done by any person ordinarily skilled in the art without departing from the technical scope of the present invention.

### Explanation of the Reference Numerals and Signs

101...fixing plate, 102...light source, 111...resin substrate, 112...paste pattern, 113...fixing mechanism

## Claims

1. A pattern forming method comprising:
fixing a resin substrate, on which a paste pattern of a conductive paste is formed, on a fixing plate made of a metal having a thermal capacity per unit volume of 3,000 [kJ/m³·K] or more and a thermal conductivity of 45 [W/m·K] or more; and
baking the paste pattern by irradiating the paste pattern formed on the resin substrate fixed to the fixing plate with near infrared rays, thereby forming a conductive pattern on the resin substrate.

2. The pattern forming method according to claim 1, wherein
a peak wavelength range of the near infrared rays is 0.8 to 1.7 µm.

3. The pattern forming method according to claim 1 or 2, wherein
the resin substrate is fixed to the fixing plate by a fixing mechanism.

4. The pattern forming method according to claim 3, wherein
the fixing mechanism is an adhesive layer that fixes the resin substrate to the fixing plate.

5. A baking apparatus comprising:
a fixing plate made of a metal having a thermal capacity per unit volume of 3,000 [kJ/m³·K] or more and a thermal conductivity of 45 [W/m·K] or more; and
a light source configured to irradiate, with near infrared rays, a paste pattern on a resin substrate which is fixed on the fixing plate and on which the paste pattern of a conductive paste is formed.

6. The baking apparatus according to claim 5, wherein
a peak wavelength range of the near infrared rays is 0.8 to 1.7 µm.

7. The baking apparatus according to claim 5 or 6, further comprising
a fixing mechanism configured to fix the resin substrate to the fixing plate.

8. The baking apparatus according to claim 7, wherein
the fixing mechanism is formed by an adhesive layer.
